(19) Europäisches Patentamt
European Patent Office
Office européen des brevets

(11) EP 2 448 861 B1

(12) # FASCICULE DE BREVET EUROPEEN

(45) Date de publication et mention de la délivrance du brevet:
**12.03.2014 Bulletin 2014/11**

(21) Numéro de dépôt: **10726987.0**

(22) Date de dépôt: **01.07.2010**

(51) Int Cl.:
***B81C 1/00*** *(2006.01)*

(86) Numéro de dépôt international:
**PCT/EP2010/059335**

(87) Numéro de publication internationale:
**WO 2011/000898 (06.01.2011 Gazette 2011/01)**

(54) **Procédé de collage cuivre-cuivre simplifié**

Vereinfachtes Kupfer-Kupfer-Haftverfahren

Simplified copper-copper adhering method

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **03.07.2009 FR 0954608**

(43) Date de publication de la demande:
**09.05.2012 Bulletin 2012/19**

(73) Titulaires:
- **Commissariat à l'Énergie Atomique et aux Énergies Alternatives 75015 Paris (FR)**
- **STMicroelectronics (Crolles 2) SAS 38920 Crolles (FR)**

(72) Inventeurs:
- **DI CIOCCIO, Léa F-38330 Saint Ismier (FR)**
- **GUEGUEN, Pierric F-38130 Echirolles (FR)**
- **RIVOIRE, Maurice F-38240 Meylan (FR)**

(74) Mandataire: **Ilgart, Jean-Christophe Brevalex 95, rue d'Amsterdam 75378 Paris Cedex 8 (FR)**

(56) Documents cités:
**WO-A2-2006/052763**
**US-A1- 2008 001 241**
**US-B1- 6 376 280**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 2 448 861 B1

Printed by Jouve, 75001 PARIS (FR)

## Description

### DOMAINE TECHNIQUE ET ART ANTÉRIEUR

La présente invention se rapporte au collage métal-métal, plus particulièrement au collage cuivre-cuivre simplifié, notamment utilisable dans la réalisation de dispositifs microélectroniques.

L'intégration en trois dimensions dans les dispositifs microélectroniques permet en autre de réduire la taille des dispositifs, de réduire leur consommation électrique, d'augmenter les vitesses de transmission, les performances, la fréquence de fonctionnement...

Une intégration en trois dimensions comporte notamment les étapes de collage avec alignement, d'amincissement et d'interconnexion verticale à travers l'empilement.

On utilise la technologie TSV (Through Silicon Via) qui consiste à réaliser des via de connexion à travers le silicium. Cependant pour obtenir une densité d'interconnexion élevée et pour simplifier la technologie, il est préférable de les associer à un collage métal-métal directement.

Le cuivre est un des métaux particulièrement utilisés pour réaliser des plots de connexion.

Il existe différentes méthodes pour réaliser un collage direct cuivre-cuivre : par thermocompression ou sous ultravide, les surfaces ayant été activées au moyen d'un plasma argon. Ces méthodes permettent d'obtenir de bons résultats, cependant elles nécessitent soit un ultravide pour la préparation des surfaces, soit une température élevée pour réaliser le collage, soit de travailler sous une atmosphère particulière. L'application d'une pression peut endommager les MEMS. Le document US 6 376 260 décrit un procédé de collage cuivre-cuivre par thermocompression.

C'est par conséquent un but de la présente invention d'offrir un nouveau procédé de collage cuivre-cuivre direct.

### EXPOSÉ DE L'INVENTION

Le but précédemment énoncé est atteint par un procédé de collage cuivre-cuivre, comportant un étape de génération d'une couche cristalline de cuivre enrichie en oxygène de quelques nanomètres d'épaisseur sur chacune des faces à mettre en contact et de mise en contact de ces deux faces, cette étape de génération d'une couche cristalline de cuivre enrichie en oxygène comprenant les étapes de polissage et de nettoyage des surfaces de cuivre,

Les inventeurs ont constaté, de manière surprenante, que la présence d'une couche cristalline de cuivre enrichie en oxygène sur les surfaces de cuivre permettait de coller les deux surfaces et d'obtenir un assemblage électriquement conducteur.

De manière avantageuse, le collage selon la présente invention peut se faire à température ambiante, à pression atmosphérique, à l'air, sans colle, sans pression spécifique et sans recuit. Le fait de travailler à température ambiante permet d'améliorer l'alignement des plaques à coller ou des éléments portés par les plaques, puisque l'on évite l'apparition d'une différence de courbure entre les plaques.

On peut prévoir qu'une légère pression soit exercée sur un bord de l'empilement pour initier le collage.

Le procédé selon la présente invention, du fait de l'absence de pression au collage, permet d'avoir un bon alignement entre les plaques

La présente inventons a alors pour objet un procédé de collage d'un premier élément en cuivre sur un deuxième élément en cuivre comportant au moins :

A) une étape de formation d'une couche cristalline de cuivre enrichie en oxygène sur chacune des surfaces de chacun des premier et deuxième éléments par lesquelles les éléments seront en contact, l'épaisseur totale des deux couches étant inférieure à 6 nm,
B) une étape de mise en contact des deux couches cristallines de cuivre enrichies en oxygène,
ladite étape A) comprenant :

a) au moins une étape de polissage des surfaces de sorte à obtenir une rugosité inférieure à 1 nm RMS, et des surfaces hydrophiles,
b) au moins une étape de nettoyage des dites surfaces afin de supprimer la présence de particules dues au polissage et la majeure partie des inhibiteurs de corrosion.

Avantageusement, la rugosité est inférieure à 0,5 nm RMS.

L'étape B) a avantageusement lieu à température ambiante, à pression atmosphérique et à l'air.

De manière préférée, l'étape B) a lieu dans les deux heures suivant l'étape b).

Le procédé de collage selon l'invention peut comporter une étape d'application d'un effort sur l'un des éléments tendant à rapprocher les deux couches cristallines de cuivre enrichies en oxygène de sorte à initier le collage. L'application de l'effort a avantageusement lieu uniquement sur un bord d'un des éléments.

On peut orienter les plans denses des éléments en cuivre sensiblement parallèlement aux surfaces de collage.

Les éléments de cuivre peuvent comporter un substrat, une couche de diélectrique munie de gravures déposée sur le substrat, une couche de cuivre recouvrant le diélectrique et remplissant les gravures de la couche diélectrique, ladite couche de cuivre comportant des marches au niveau des gravures, dans lequel l'étape a) comporte par exemple les sous étapes suivantes :

a1) polissage mécano-chimique de la couche de cuivre de chaque élément avec une solution chimique aplanissante jusqu'à disparition des marches et obtention d'une surface de cuivre sensiblement plane,
a2) polissage mécano-chimique de la couche de cuivre restante avec une solution chimique non aplanissante sélective par rapport au diélectrique jusqu'à retrait total du cuivre sur le couche diélectrique en dehors de gravures, le cuivre restant au même niveau que le diélectrique ou en retrait de la surface du diélectrique ;
a3) polissage mécano-chimique du diélectrique avec une solution chimique aplanissante jusqu'à ce que la surface du diélectrique soit sensiblement au niveau de la surface des plots.

Les éléments peuvent comporter une barrière de diffusion entre le diélectrique et la couche de cuivre, lors de l'étape a2), la couche de cuivre est polie jusqu'à sa disparition sur la barrière de diffusion en dehors de gravures, et lors de l'étape a3), la barrière de diffusion est polie avant le diélectrique ou à la place du diélectrique.

Le procédé selon l'invention peut comporter une étape supplémentaire C) de recuit après l'étape B).

Le premier élément est par exemple sous forme de plaque de cuivre ou de plots affleurant une surface d'un matériau diélectrique et le deuxième élément est sous forme de plaque ou de plots affleurant une surface de matériau diélectrique.

La présente invention a également pour objet un procédé de réalisation d'un dispositif microélectronique comprenant une structure de microsystème électromécanique dans une cavité hermétique comprenant :

- une étape de réalisation d'un premier élément muni d'une structure de microsystème électromécanique entourée par une première paroi en cuivre formant un contour fermé, le sommet de ladite première paroi étant formé par une face plane,
- une étape de réalisation d'un deuxième élément muni d'une deuxième paroi dont le sommet est formé par une face plane de forme et de dimensions similaires à celle de la première paroi du premier élément, la somme des hauteurs des première et deuxième parois étant supérieur à la hauteur de la structure de microsystème électromécanique,
- une étape de polissage des faces planes des parois de chacun des premier et deuxième éléments par lesquelles les éléments seront en contact de sorte à obtenir une rugosité inférieure à 1 nm RMS, avantageusement inférieure ou égale à 0,5 nm RMS,
- une étape de nettoyage des dites faces afin de supprimer la présence de particules dues au polissage et d'inhibiteurs de corrosion,
- une étape de mise en contact avec de l'oxygène et de formation d'une couche cristalline de cuivre enrichie en oxygène sur chacune des faces planes, l'épaisseur totale des deux couches étant inférieure à 6 nm,
- une étape de mise en contact des deux couches cristallines de cuivre enrichies en oxygène de sorte à seller la structure de microsystème électromécanique dans une cavité étanche délimitée par les premier et deuxième éléments et les première et deuxième parois.

Le procédé peut comporter une étape de contrôle de l'atmosphère au sein de la cavité ainsi formée. L'étape de mise en contact s'effectue avantageusement sous vide.

## BRÈVE DESCRIPTION DES DESSINS

La présente invention sera mieux comprise à l'aide de la description qui va suivre et des dessins en annexe sur lesquels :

- les figures 1A à 1E sont des vues schématiques des différentes étapes du procédé selon la présente invention appliqué à un collage d'éléments structurés,
- la figure 2 est une photographie d'une interface de collage obtenue par le procédé selon la présente invention avant recuit,
- la figure 3 est une représentation graphique de l'évolution de l'énergie de liaison en $J/m^2$ d'un collage plaque cuivre-plaque de cuivre selon la présente invention et d'un collage d'une plaque de cuivre avec une plaque de $SiO_2$ selon la présente invention en fonction des températures de recuit en °C,
- la figure 4 est une représentation graphique de l'évolution de l'énergie de liaison en $J/m^2$ d'un collage cuivre-cuivre selon la présente invention après un recuit de 30 min, et d'un collage $SiO_2$- $SiO_2$ après un recuit de 2 heures,

- la figure 5A est une représentation graphique de l'évolution de la tension (en mV) en fonction de l'intensité (en mA) au sein d'une connexion cuivre-cuivre obtenue par le procédé de collage selon l'invention et de détermination de la résistance électrique (en mΩ) de cette connexion,
- la figure 5B est une vue de dessus de la connexion considérée pour les mesures représentée sur la figure 5A,
- les figures 6A et 6B sont des représentations schématiques de l'évolution de l'interface de collage obtenue selon la présente invention après recuit,
- la figure 7 est une représentation schématique d'un MEMS encapsulé grâce au procédé selon la présente invention.

## EXPOSÉ DÉTAILLÉ DE MODES DE RÉALISATION PARTICULIERS

Le procédé selon la présente invention consiste à réaliser un collage moléculaire entre deux éléments en cuivre.

Ces deux éléments peuvent être chacun une plaque de cuivre, une couche de cuivre ou des plots de connexion ou des lignes de connexion, dont une face affleure d'un substrat en matériau isolant. Ou encore l'un des éléments peut être une plaque de cuivre et l'autre élément un ensemble de plots dont une face affleure d'un substrat isolant.

Le collage moléculaire est compris comme le collage par adhésion moléculaire au cours duquel deux surfaces planes adhèrent l'une à l'autre sans application de colle.

Sur la figure 1A, on peut voir une représentation schématique d'un des deux éléments 2, 4 à coller. Dans l'exemple représenté, les deux éléments sont symétriques, comme on peut le voir sur la figure 1E ; un seul sera décrit en détail. L'élément 2 comporte un substrat 6, par exemple en silicium recouvert d'une couche en matériau diélectrique 8, par exemple en $SiO_2$ et des plots 10 en cuivre réalisés dans la couche diélectrique 8.

Sur la figure 1A qui correspond à l'élément avant polissage, une couche de cuivre 12 est déposée sur la couche diélectrique 8 et remplit les zones évidées destinées aux plots. Dans l'exemple représenté, une couche 9 supplémentaire formant barrière de diffusion, par exemple en TiN, est déposée sur la couche diélectrique 8 avant le dépôt de la couche de cuivre 12.

L'élément 4 comporte des plots 14 (figure 1E).

Le procédé selon la présente invention a pour objet d'assembler ces deux éléments 2, 4, plus particulièrement de coller les plots 14 sur les plots 10.

Le procédé selon la présente invention comporte :

- une étape A) de formation d'une couche cristalline de cuivre enrichie en oxygène sur chacune des surfaces de chacun des premier et deuxième éléments par lesquelles les éléments seront en contact, l'épaisseur totale des deux couches étant inférieure à 6 nm, et
- une étape B) de mise en contact des surfaces induisant un collage moléculaire hydrophile des deux éléments par lesdites surfaces à température ambiante et à pression atmosphérique.

L'étape A) comprenant :

a) une étape de polissage des éléments 2, 4 de sorte à libérer des surfaces munies de plots 10, 14, dont les faces libres 10.1, 14.1 présentent une rugosité inférieure à 1 nm RMS, avantageusement inférieure ou égale à 0,5 nm RMS,
b) une étape de nettoyage des dites surfaces 10.1, 14.1 afin de supprimer la présence de particules dues au polissage. A la fin de cette étape, les faces libres 10.1, 14.1 présentent un caractère hydrophile,

Par exemple l'épaisseur de la couche cristalline de cuivre enrichie en oxygène sur chaque plot 10, 14 est comprise entre l'épaisseur d'une monocouche, i.e. de l'ordre de 1 Å jusqu'à environ 3 nm. On entend par couche cristalline de cuivre enrichie en oxygène, une couche cristalline de cuivre comportant de l'oxygène qui peut aller de la couche adsorbée jusqu'à l'oxyde de cuivre stoechiométrique.

Dans la présente demande, une surface est considérée comme hydrophile si l'angle de contact est compris entre 0° et 20°, de préférence le plus faible possible.

Les différentes étapes seront décrites en détail dans la description qui va suivre.

Pour effectuer le collage entre les plots de cuivre, on cherche à obtenir des faces 10.1, 14.1 offrant une très grande planéité de sorte que, lors de leur mise en contact, le contact entre les faces soit sensiblement parfait. A cet effet, on cherche à obtenir une rugosité inférieure à 1 nm RMS (Root Mean Square value), avantageusement inférieure ou égale à 0,5 nm RMS

Un exemple de polissage est donné ci-dessous, mais celui-ci n'est en aucun limitatif et tout autre procédé permettant d'atteindre une rugosité inférieure à 1 nm RMS est utilisable.

L'étape de polissage a) permet passer de la structure de la figure 1A à la structure de la figure 1D.

Nous ne décrirons que le polissage de l'élément 2, le polissage de l'élément 4 s'effectuant de manière similaire. On effectue un polissage mécano-chimique ou CMP (« Chemical Mechanical Polishing » en anglais), pour aplanir les

motifs obtenus après dépôt de la couche de cuivre 12 sur le substrat 6.

Les figures 1A à 1D représentent les différents états de l'élément 2 lors des différentes étapes de polissage.

La figure 1 représente l'élément 2 après le dépôt de la couche de cuivre 12 et avant le début du polissage. Le diélectrique 8 a été gravé et comporte des gravures 11. Dans l'exemple représenté, le diélectrique 8 est recouvert d'une barrière de diffusion 9, par exemple en TiN. La couche de cuivre 12 comporte des zones en retrait 13 formant des marches au niveau des gravures 11.

Lors d'une première étape de polissage a1) aplanit la couche de cuivre pour obtenir la configuration de la figure 1B, les zones en retrait 13 ont disparu. Pour cela, on effectue un polissage mécano-chimique avec un produit chimique aplanissant. Un produit chimique ou slurry est dit « aplanissant », lorsqu'il permet de réduire les marches présentes après dépôt de matière sur une structure. L'épaisseur de cuivre restant est comprise entre 50 nm et 200 nm.

Sur la figure 1B la couche 12 est sensiblement plane.

Ensuite, lors d'une étape a2) on effectue un polissage destiné à retirer la couche de cuivre sur la barrière de diffusion en dehors des gravures, jusqu'à ce que le cuivre dans les gravures soit en retrait de la surface de l'élément 4. Pour cela, on effectue un polissage mécano-chimique avec un slurry non aplanissant et sélectif sur la barrière de diffusion ou le diélectrique, i.e. qu'il attaque le cuivre et pas la barrière ou le diélectrique. Grâce au choix de ce slurry, le cuivre dans les gravures est sensiblement plan et est en retrait de manière homogène de la surface de l'élément 4, i.e. en retrait de la barrière de diffusion. Il n'y a pas apparition d'un profil en cuvette. Ceci est obtenu quelles que soient les dimensions des gravures. On obtient la structure de la figure 1C. Ce retrait peut être ajusté par les paramètres de polissage comme la pression d'appui de la plaque sur le tissu ou le temps de polissage. Ce retrait peut aussi être ajusté en fonction de la solution chimique de polissage et notamment avec les agents complexant et ou avec les inhibiteurs de corrosion. On pourrait cependant avoir également un polissage de a barrière et un arrête sélectif sur le diélectrique.

Lors d'une étape suivante a3), on réalise le retrait de la barrière de diffusion et éventuellement du diélectrique pour ramener la surface de la barrière ou du diélectrique sensiblement au niveau de la surface des plots de cuivre 10, un écart de plus ou moins 5 nm existe ente la surface des plots et celle de la barrière ou du diélectrique. Pour cela, on effectue un polissage mécano-chimique avec un slurry aplanissant. Dans cette étape, à la fois le cuivre, le diélectrique et la barrière sont polis à des vitesses différentes. Ces vitesses sont ajustées avec la composition du slurry en tenant compte des matériaux à polir, des largeurs et densités des cavités des plaques et la topographie finale voulue.

En cas de retrait de la surface des plots de cuivre par rapport à la surface de la barrière ou du diélectrique, on utilisera avantageusement un traitement thermique après la mise en contact des surfaces pour favoriser le contact entre les surfaces de cuivre par dilatation du cuivre.

Nous allons maintenant décrire plus en détail les moyens qui peuvent être mis en oeuvre pour effectuer le polissage mécano-chimique pour la réalisation de la présente invention.

La surface de l'élément 2 à polir est frottée sur un tissu appelé "pad" composé de polyuréthane poreux viscoélastique et dont les propriétés (dureté, compressibilité, forme et dimension des pores ainsi que des motifs...) dépendent de la nature du matériau à polir. Le ou les matériaux à la surface de l'élément 2 est (sont) arraché(s) par réaction chimique et action mécanique à l'aide du tissu et/ou d'une solution contenant des particules appelée "slurry" (particules en suspension dans une solution chimique acide ou basique). Ces slurries peuvent être composés de particules de tailles nanométriques dans une solution liquide (solution colloïdale, micelles, langmuir-blodget, etc.).

Le polissage est obtenu par la combinaison de plusieurs actions :

- une action mécanique obtenue par le frottement du tissu et/ou des particules du slurry sur la surface. La vitesse d'enlèvement du matériau a été modélisée par Preston selon l'équation suivante :

$$RR = K_p * P * V \quad [1]$$

  avec :

  RR (Removal Rate) : taux d'enlèvement en un point donné (en nm/min),
  $K_p$ = Constante de Preston prenant en compte les caractéristiques du matériau, du tissu, du type d'abrasif, de la température...
  P = Pression appliquée (en Newton),
  V = Vitesse linéaire d'un point de la plaque par rapport au tissu (en m/s),

- une action chimique ; lors du polissage, on souhaite à la fois polir du cuivre et le matériau diélectrique. Les slurries sont donc adaptés pour avoir une action chimique sur le cuivre et sur le matériau diélectrique. Concernant le cuivre, l'action chimique provient généralement d'une attaque par un acide et/ou d'un oxydant permettant de réagir avec

la surface à polir.

Généralement, un slurry est constitué par la présence d'agent chimique d'attaque des métaux, d'un oxydant (généralement $H_2O_2$), d'un agent stabilisateur du pH ajouté à la solution acide ou basique du slurry et d'un inhibiteur de corrosion. La solution chimique va passiver (K1) le matériau en formant à sa surface un oxyde métallique qui sera enlevé mécaniquement (K2) par le tissu et par les éventuelles particules du slurry. La solution chimique va alors formée du $CuO_x$.

$$Cu + OX \xrightarrow{k_1} CuOX^* \xrightarrow{k_2} CuOX$$

Cette réaction chimique facilite et accélère le mécanisme de polissage. D'autres réactions chimiques peuvent être engendrées par la formation de cations métalliques cuivre/cuivre ou cuivre/$Cu^{2+}$ solubles et retirés de la surface à polir par le tissu et ou les particules du slurry.

Pour le matériau diélectrique, les slurries utilisés généralement sont des solutions aqueuses. L'eau a une grande importance pour le polissage de diélectrique, par exemple d'un oxyde de silicium. Deux réactions chimiques interviennent.

Tout d'abord, l'eau pénètre sous l'effet de la pression et casse certaines liaisons Si - O de l'oxyde de silicium pour former une surface hydratée. La séparation des liaisons (Si-O-Si) est contrôlée par la diffusion de l'eau dans la silice. Le polissage se réalise lorsque la réaction d'hydratation réversible (polymérisation) suivante :

$$(SiO_2)_x + 2H_2O \leftrightarrow (SiO_2)_{X-1} + Si(OH)_4$$

peut se produire dans le sens inverse, c'est-à-dire dans de le sens de l'hydratation (dépolymérisation), comme cela est décrit notamment dans l'ouvrage *"Handbook of Semiconductor Interconnection Technology"* par GC Schwarz.

Le mouvement du tissu par rapport à la plaque de silicium permet alors d'arracher les particules de slurry de la surface emportant ainsi des atomes du matériau superficiel.

Afin d'effectuer une attaque chimique à la fois du cuivre et du matériau diélectrique, on peut utiliser une solution aqueuse obtenue par solubilisation dans de l'eau désionisée :

- d'un ou deux agents complexant ou d'attaque chimique des métaux et des éventuels composés métalliques (glycine, NH3, EDTA, etc) qui permet d'augmenter la vitesse de polissage du cuivre,
- d'un inhibiteur de corrosion du cuivre (benzotriazole BTA, triazole TA..), agent passivant le film de cuivre réduit la vitesse de polissage spécifiquement dans les zones basses à aplanir. Souvent deux inhibiteurs sont utilisés,
- d'un surfactant pour stabiliser le pH, améliorer la sélectivité de polissage du cuivre vis-à-vis des autres matériaux utilisés....
- d'un agent oxydant ($H_2O_2$, $KIO_3$, hydroxylamine, etc....) qui suivant le pH et/ou sa concentration peut former soit une passivation du cuivre par un oxyde ou hydroxyde de cuivre insoluble, soit une corrosion par un cation métallique soluble dans la solution aqueuse,
- de particules colloïdales anionique ou cationique, présentant un pH compris entre 1 et 12 sont avantageusement ajoutées pour obtenir une suspension stable de particules. Les particules peuvent être pures comme la silice, du carbone, l'oxyde de cérium, l'alumine ou des polymères. Les tailles des particules élémentaires seront déterminées par la méthode de mise en solution choisie. Elles pourront varier de 3nm à 300nm. Le pourcentage massique de particules dans la solution aqueuse pourra être compris entre quelques ppm et 50 %.

A titre d'exemple, les solutions aqueuses suivantes peuvent être utilisées :

- pour l'étape a1), on peut utiliser le slurry EPL2361 vendu par la société CMC (Cabot Mircoelectronic Corporation), ou CoppeReady®CU3900 de DANM (Dupont Air Product Nanomaterials L.L.C),
- pour l'étape a2), on peut utiliser le slurry DP510 de DANM ou RL3000 de Rohm & Haas, ou HS-C930-3 de Hitachi ou C7092 de CMC,
- pour l'étape a3), on peut utiliser le slurry CuS-1351 de Rohm & Haas, ou B8500 de CMC, ou DP6545 de DANM, ou T815 de Hitachi, ou FCB-837 de Fujimi corporation.

Les caractéristiques des tissus de polissage utilisés dépendent notamment des dimensions des cavités creusées dans un matériau isolant et remplies de cuivre avec ou sans barrière de diffusion ou couche d'adhésion.

A titre d'exemple, pour des cavités d'une largeur supérieure à 10 $\mu$m, on choisit des tissus dits d'aplanissements

en polyuréthane avec une dureté classée en « shore D » de 50 à 70, d'une densité de 60 à 90 mg/$cm^3$, et d'une compressibilité inférieure à 4 %, par exemple le IC1000 de la société Rohm & Haas, ou le D100 de la société CMC.

Pour des cavités inférieures à 10 $\mu$m, on peut choisir par exemple des tissus dits médiums, avec une dureté classée en « shore A » de 50 à 70, d'une densité de 20 à 40 mg/$cm^3$, et d'une compressibilité entre 10 et 25 %. Pour cette application, par exemple le Suba IV de la société Rohm & Haas.

Pour des cavités de l'ordre du micromètre, certains matériaux ductiles risquant d'être rayés par les particules, des tissus de polissage dits de finitions sont préférés, avec une dureté classée en « shore A » de 50 à 80, d'une densité de <20 mg/$cm^3$, et d'une compressibilité >30 %, par exemple le POLITEX® de la société Rohm & Haas, ou des tissus de la marque Fujibo®.

Les éléments sont par exemple traités sur des polisseuses classiques par exemples de types Mirra ou Reflexion de Applied Materials USA, Megapol M550 de Alpsitec France ou FREX de Ebara Japon.

Les paramètres de polissage sont la pression d'appui exercée sur le substrat comprise entre 0,02 daN/$cm^2$ à 1 daN/$cm^2$ la vitesse d'un point du substrat par rapport à un point du tissu est comprise entre 0,1 m/s à 3 m/s, le débit de la solution aqueuse entre 5 et 300ml pour des substrats variant de 1 à 450 mm, la température étant comprise entre 2 et 70°C. Préférentiellement les conditions pour les applications précitées sont de 0,1 daN/cm2, avec une vitesse de 1 m/s, un débit de solution aqueuse de 150ml pour des substrats de 200mm à une température de 52°C.

Lors de l'étape b), les deux éléments, plus particulièrement les faces de deux éléments, à mettre en contact sont rincés afin de supprimer les particules résiduelles qui pourraient restées suite au polissage, ainsi que le ou les inhibiteurs de corrosion du cuivre. Le rinçage est effectué, par exemple au moyen d'une solution alcaline.

Les surfaces ainsi formées présentent un fort caractère hydrophile.

Après l'étape b), chacune des faces des éléments à mettre en contact comporte une couche cristalline de cuivre enrichie en oxygène. La couche cristalline de cuivre enrichie en oxygène est présente sur les faces libres 14.1, 16.1 des plots. Cette couche s'est formée par mise en contact de faces libres avec une atmosphère oxydante.

Le temps s'écoulant avant la mise en contact est maîtrisé de cette étape de sorte que l'épaisseur totale de la couche cristalline de cuivre enrichie en oxygène formée par les deux couches portées par chacun des éléments, lors de la mise en contact des deux surfaces soit inférieure à 6 nm. Par exemple, on cherche à obtenir, sur chacun des plots, une couche d'oxyde comprise ente 1 Å (i.e. de l'ordre d'une monocouche) et 3 nm d'épaisseur.

Le temps maximal entre la fin du nettoyage et la mise en contact est avantageusement d'environ 2 heures. Au-delà, les faces libres peuvent ne plus présenter un caractère hydrophile.

Il est possible de préparer à nouveau les surfaces pour les rendre aptes au collage.

Pour cela, on retire la ou les couches de cuivre enrichie en oxygène au moyen d'un plasma en veillant à ne pas augmenter la rugosité de la ou des surfaces. Les surfaces sont alors prêtes pour une nouvelle étape de formation cristalline de cuivre enrichie en oxygène.

De manière préférée, il s'agit d'un plasma $He/H_2$, qui présente l'avantage de n'attaquer que la couche de cuivre enrichie en oxygène et de ne pas modifier la rugosité de la couche de cuivre. L'action d'un tel plasma est par exemple décrite dans le document "Reduction of CuO and Cu2O with H2: Embeding and Kinetic Effects in the Formation of Suboxides", Jae Y.3 Kimnd al, in JACS 2003, page 10684-10692.

A la fin de cette étape, les deux éléments, plus particulièrement les faces libres des plots 10.1, 14.1, sont prêtes à être mises en contact pour effectuer le collage moléculaire.

Les faces 10.1, 14.1 sont mises en contact, chaque face 14.1 d'un plot d'un l'élément étant alignée avec une face 10.1 d'un plot de l'autre élément.

La mise en contact s'effectue avantageusement à température ambiante et à pression atmosphérique sous air.

La simple mise en contact permet d'obtenir un collage des deux faces. On obtient alors un ensemble présentant une très bonne conductivité électrique entre le premier et le deuxième élément et une très bonne tenue mécanique.

On peut prévoir d'initier le collage en appliquant une légère pression à une extrémité de l'assemblage. Cette effort est exercé au début et n'a pas besoin d'être maintenue pendant tout le collage. Cette légère pression rapproche les deux surfaces et accélère le collage. Par exemple, le collage d'une surface de 8 pouces peut être effectif en moins d'une minute.

Cette pression est exercée avantageusement en un point du bord de la plaque supérieure, ce qui évite l'apparition de deux propagations et les risques d'apparition d'une zone non collée lorsque les deux propagations se rencontrent.

On peut effectuer un recuit de l'ensemble ainsi formé. La couche cristalline de cuivre enrichie en oxygène « se dissout », l'oxygène se regroupe en « îlot » préférentiellement au niveau des défauts d'interface, par exemple vers des cavités induites par la migration de lacunes ou vers des reste de rugosité, par exemple tous les 100 nm. Ces cavités ne gênent pas la conductivité électrique, ni la tenue mécanique. En dehors des cavités, on obtient un contact cuivre-cuivre.

On peut prévoir de mettre en oeuvre des éléments dont l'orientation cristallographique du cuivre est déterminée. Par exemple, on peut choisir que le plan dense soit parallèle à l'interface, i.e. on oriente les plans (111) parallèles à l'interface de collage. On observe que l'oxygène de l'oxyde de cuivre est alors emprisonné au niveau de l'interface et

ne se diffuse pas dans les éléments en cuivre.

Grâce à la présente invention, on réalise de manière très simple et très efficace le collage de deux éléments en cuivre.

Sur la figure 2, on peut voir la photographie de l'interface de collage cuivre-cuivre selon la présente invention avant recuit, l'échelle sur le côté droit indique l'épaisseur totale de la couche cristalline de cuivre enrichie en oxygène.

Sur la figure 3, est représenté l'évolution de l'énergie de liaison en $J/m^2$ entre deux éléments en fonction des température de recuit en °C, la durée du recuit étant de 30 min, le courbe en trait plein représente l'évolution de l'énergie de liaison pour un collage de plaque cuivre-plaque de cuivre selon la présente invention , la courbe en pointillé représente l'évolution de l'énergie de liaison d'un collage d'un plaque de cuivre avec une plaque de $SiO_2$. Les mesures sont effectuées par DCB (Double cantilever beam) et par imagerie acoustique. On remarque que le collage selon la présente invention offre une énergie de liaison supérieure quelle que soit la température de recuit et même en l'absence de recuit (à 25°C).

La figure 4 représente l'évolution de l'énergie de liaison en $J/m^2$ entre deux éléments pleine plaques en fonction des température de recuit en °C déterminée par la méthode DCB et par imagerie acoustique, la courbe en trait fin représente l'évolution de l'énergie de liaison pour un collage cuivre-cuivre selon la présente invention après un recuit de 30 min, la courbe en trait épais représente l'évolution de l'énergie de liaison d'un collage $SiO_2$-$SiO_2$ après un recuit de 2 heures. On remarque que le collage selon la présente invention offre une énergie de liaison supérieure quelque soit la température de recuit. La courbe en pointillé représente l'évolution de l'énergie de liaison par collage cuivre-cuivre selon la présente invention mesurée par la méthode dite « Four Point Bending ». Au-delà d'un recuit à 100°C, l'énergie de liaison est trop forte pour être mesurée.

La figure 5A représente l'évolution de la tension en mV en fonction du courant en mA traversant une connexion cuivre-cuivre 20 obtenues par collage selon la présente invention représentée sur la figure 5B. La surface de contact cuivre-cuivre est de 100 $\mu m^2$. La connexion a subi un recuit de 30 min à 200°C. Des triangles représentent la résistance électrique en m$\Omega$ de cette connexion. La résistance de cette connexion est 9,8 m$\Omega$, ce qui correspond à une conductivité électrique spécifique du contact de 0,98 $\Omega.\mu m^2$ On constate donc que la connexion cuivre-cuivre selon la présente invention offre en très bonne conductivité électrique.

Le procédé selon la présente invention offre l'avantage d'être applicable au collage plaque-plaque ou puce-plaque.

Le procédé selon la présente invention s'effectuant à température ambiante, il est possible d'effectuer un collage sur une plaque implantée.

Comme décrit précédemment, l'ensemble ainsi formé peut subir une étape de recuit ; sur les figures 6A et 6B, on peut voir l'effet d'un tel recuit sur l'interface de collage entre deux éléments I, II.

Les éléments I, II présentent tous deux des petits grains 28.

Après le collage selon la présente invention, un recuit est appliqué aux deux éléments I, II' collés, formant un élément III. Une restauration s'opère, provoquant la formation de gros grains 30 dans les deux éléments I, II collés et la « disparition » de l'interface du collage.

Cette restauration homogène en gros grains améliore la tenue mécanique de l'assemblage et la conductivité électrique entre les deux éléments I, II, du fait de la disparition de l'interface de collage.

Par exemple, les lignes mesurent au moins 10 nm de large.

La température du recuit de restauration est fonction du substrat processé sur lequel les lignes de cuivre sont réalisées, la température de recuit est comprise entre 200°C et 400°C. La durée du recuit est fonction de la température de recuit, plus la température est élevée, plus le durée du recuit peut être réduite.

Le procédé de collage selon la présente invention permet avantageusement d'encapsuler des microsystèmes électromécaniques ou MEMS (Microelectromechanical systems), actionneurs ou capteurs dans une cavité hermétique au gaz et à l'humidité, de manière à, par exemple, limiter son vieillissement ou augmenter la fiabilité des mesures.

Selon la présente invention et comme cela est représenté sur la figure 7, on réalise un premier élément I' sur lequel est formé un MEMS 18 et un deuxième élément II' destiné à délimiter avec le premier élément une cavité hermétique 20 dans laquelle est encapsulé le MEMS 18.

Pour cela, le premier élément I' comporte une première paroi 22 entourant le MEMS 18 de sorte à former un contour fermé autour du MEMS 18. La première paroi a par exemple une forme de couronne. La première paroi 22 comporte une face latérale intérieure 22.1, une face latérale extérieure 22.2, un fond 22.3 en contact avec le premier élément I' et un sommet 22.4. Le sommet 22.4 forme une face plane.

Le deuxième élément II' comporte une deuxième paroi 24 en cuivre de forme et de dimensions similaires à celles de la première paroi 22, comportant un sommet 26 formant une face plane.

La somme des hauteurs de la première et de la deuxième paroi est supérieure ou égale à la hauteur du MEMS 18, évitant une interaction mécanique entre le MEMS 18 et les parois de la cavité.

Les faces planes 22.4 et 26 sont préparées suivant les étapes a), b) et c), puis sont mises en contact selon l'étape d).

On obtient alors une seule paroi 28 étanche définissant avec les deux éléments I', II' une cavité étanche.

On obtient alors, comme décrit précédemment un collage cuivre-cuivre direct à température ambiante et à pression atmosphérique. Il n'y a alors aucun risque d'endommagement du MEMS.

Il peut être souhaitable de contrôler l'atmosphère à l'intérieur de la cavité, par exemple par un gaz neutre permettant d'éviter toute réaction chimique, ou de sceller la cavité sous un vide plus ou moins poussé. Il est alors aisé, grâce au scellement selon la présente invention, de contrôler cette atmosphère.

Le vide au sein de la cavité peut être effectué après le collage ou, avantageusement, on effectue l'étape d) de mise en contact sous vide, ce qui simplifie le procédé de scellement.

Le scellement obtenu est de très bonne qualité, à la fois du point de vue mécanique et du point de vue de l'étanchéité.

En outre, la paroi 28 est électriquement conductrice, ce qui permet d'alimenter le MEMS comme cela est schématisé sur la figure 6 par la connexion 30.

Les parois 22 24 sont réalisées par des procédés microélectroniques classiques.

Ce procédé d'encapsulation est particulièrement avantageux au vu des autres procédés de l'état de la technique. En effet, les technologies de surface appropriées, connue sous la dénomination de «packaging couche mince», ne permette pas d'obtenir un très bon vide ou une atmosphère contrôlée dans la cavité.

La technologie consistant à reporter un capot par scellement hermétique autour du microsystème («Waferlevelpackaging») nécessite une colle en polymère, qui présente de piètres performances en ce qui concerne l'herméticité.

Grâce au procédé selon la présente invention, on réalise un collage entre deux éléments en cuivre à pression atmosphérique et à température ambiante. Ce collage présentant une grande résistance mécanique et de très bonnes propriétés de conduction électrique.

## Revendications

1. Procédé de collage d'un premier élément en cuivre sur un deuxième élément en cuivre comportant au moins :

   A) une étape de formation d'une couche cristalline de cuivre enrichie en oxygène sur chacune des surfaces de chacun des premier et deuxième éléments par lesquelles les éléments seront en contact, l'épaisseur totale des deux couches étant inférieure à 6 nm,
   B) une étape de mise en contact des deux couches cristallines de cuivre enrichies en oxygène,
   ladite étape A) comprenant :

      a) au moins une étape de polissage des surfaces de sorte à obtenir une rugosité inférieure à 1 nm RMS, et des surfaces hydrophiles,
      b) au moins une étape de nettoyage des dites surfaces afin de supprimer la présence de particules dues au polissage et la majeure partie des inhibiteurs de corrosion.

2. Procédé de collage selon la revendication 1, dans lequel la rugosité est inférieure à 0,5 nm RMS.

3. Procédé de collage selon la revendication 1 ou 2, dans lequel l'étape B) a lieu à température ambiante, à pression atmosphérique et à l'air.

4. Procédé de collage selon l'une des revendications 1 à 3, dans lequel l'étape B) a lieu dans les deux heures suivant l'étape b).

5. Procédé de collage selon l'une des revendications 1 à 4, comportant une étape d'application d'un effort sur l'un des éléments tendant à rapprocher les deux couches cristallines de cuivre enrichies en oxygène de sorte à initier le collage.

6. Procédé de collage selon la revendication 4, dans lequel l'application de l'effort a lieu uniquement sur un bord d'un des éléments.

7. Procédé de collage selon l'une des revendications 1 à 6, dans lequel les plans denses des éléments en cuivre sont orientés sensiblement parallèlement aux surfaces de collage.

8. Procédé de collage selon l'une des revendications 1 à 7, les éléments de cuivre comportant un substrat (6), une couche de diélectrique (8) munie de gravures (11) déposée sur le substrat (6), une couche de cuivre (12) recouvrant

le diélectrique (8) et remplissant les gravures (11) de la couche diélectrique (8), ladite couche de cuivre (12) comportant des marches (13) au niveau des gravures (11), dans lequel l'étape a) comporte les sous étapes suivantes :

a1) polissage mécano-chimique de la couche de cuivre (12) de chaque élément avec une solution chimique aplanissante jusqu'à disparition des marches (13) et obtention d'une surface de cuivre sensiblement plane,
a2) polissage mécano-chimique de la couche de cuivre restante avec une solution chimique non aplanissante sélective par rapport au diélectrique jusqu'à retrait total du cuivre sur le couche diélectrique (8) en dehors de gravures (11), le cuivre restant au même niveau que le diélectrique ou en retrait de la surface du diélectrique,
a3) polissage mécano-chimique du diélectrique avec une solution chimique aplanissante jusqu'à ce que la surface du diélectrique soit sensiblement au niveau de la surface des plots.

**9.** Procédé de polissage selon la revendication 8, dans lequel les éléments comportent une barrière de diffusion entre le diélectrique (8) et la couche de cuivre (12), lors de l'étape a2), la couche de cuivre est polie jusqu'à sa disparition sur la barrière de diffusion en dehors de gravures, et lors de l'étape a3), la barrière de diffusion est polie avant le diélectrique ou à la place du diélectrique.

**10.** Procédé de collage selon l'une des revendications 1 à 9, comportant une étape supplémentaire C) de recuit après l'étape B).

**11.** Procédé de collage selon l'une des revendications 1 à 10, dans lequel le premier élément est sous forme de plaque de cuivre ou de plots affleurant une surface d'un matériau diélectrique et le deuxième élément est sous forme de plaque ou de plots affleurant une surface de matériau diélectrique.

**12.** Procédé de réalisation d'un dispositif microélectronique comprenant une structure de microsystème électromécanique dans une cavité hermétique comprenant :

- une étape de réalisation d'un premier élément muni d'une structure de microsystème électromécanique entourée par une première paroi en cuivre formant un contour fermé, le sommet de ladite première paroi étant formé par une face plane,
- une étape de réalisation d'un deuxième élément muni d'une deuxième paroi dont le sommet est formé par une face plane de forme et de dimensions similaires à celle de la première paroi du premier élément, la somme des hauteurs des première et deuxième parois étant supérieur à la hauteur de la structure de microsystème électromécanique,
- une étape de polissage des faces planes des parois de chacun des premier et deuxième éléments par lesquelles les éléments seront en contact de sorte à obtenir une rugosité inférieure à 1 nm RMS, avantageusement inférieure ou égale à 0,5 nm RMS,
- une étape de nettoyage des dites faces afin de supprimer la présence de particules dues au polissage et d'inhibiteurs de corrosion,
- une étape de mise en contact avec de l'oxygène et de formation d'une couche cristalline de cuivre enrichie en oxygène sur chacune des faces planes, l'épaisseur totale des deux couches étant inférieure à 6 nm,
- une étape de mise en contact des deux couches cristallines de cuivre enrichies en oxygène de sorte à seller la structure de microsystème électromécanique dans une cavité étanche délimitée par les premier et deuxième éléments et les première et deuxième parois.

**13.** Procédé de réalisation selon la revendication 12, comportant une étape de contrôle de l'atmosphère au sein de la cavité ainsi formée.

**14.** Procédé de réalisation selon la revendication 13, dans lequel l'étape de mise en contact s'effectue sous vide.

## Patentansprüche

**1.** Verfahren zur Haftverbindung eines erstens Teils aus Kupfer mit einem zweiten Teil aus Kupfer, das zumindest umfasst:

A) einen Schritt des Bildens einer mit Sauerstoff angereicherten ersten kristallinen Schicht aus Kupfer auf jeder der Flächen jeweils des ersten und des zweiten Teils, mit welchen die Teile in Kontakt gelangen, wobei die Gesamtdicke der beiden Schichten unter 6 nm liegt,

B) einen Schritt des Inkontaktbringens der beiden mit Sauerstoff angereicherten kristallinen Kupferschichten, wobei der Schritt A) umfasst:

a) zumindest einen Schritt des Polierens der Flächen, so dass eine Rauheit von unter 1 nm RMS entsteht, sowie der hydrophilen Flächen,
b) zumindest einen Schritt der Reinigung der genannten Flächen, um aufgrund der Reinigung vorhandene Partikel und den Großteil der Korrosionsinhibitoren zu beseitigen.

**2.** Verfahren zur Haftverbindung nach Anspruch 1, wobei die Rauheit unter 0,5 nm RMS beträgt.

**3.** Verfahren zur Haftverbindung nach Anspruch 1 oder 2, wobei der Schritt B) bei Raumtemperatur unter atmosphärischem Druck und unter Luft erfolgt.

**4.** Verfahren zur Haftverbindung nach einem der Ansprüche 1 bis 3, wobei der Schritt B) innerhalb von zwei Stunden nach dem Schritt b) erfolgt.

**5.** Verfahren zur Haftverbindung nach einem der Ansprüche 1 bis 4, umfassend einen Schritt des Aufbringens einer Kraft auf eines der Teile, die geneigt ist, die beiden mit Sauerstoff angereicherten kristallinen Kupferschichten einander anzunähern, so dass die Haftverbindung eingeleitet wird.

**6.** Verfahren zur Haftverbindung nach Anspruch 4, wobei das Aufbringen der Kraft nur am Rande eines der Teile erfolgt.

**7.** Verfahren zur Haftverbindung nach einem der Ansprüche 1 bis 6, wobei die dichten Ebenen der Kupferteile im Wesentlichen parallel zu den Haftflächen ausgerichtet sind.

**8.** Verfahren zur Haftverbindung nach einem der Ansprüche 1 bis 7, wobei die Kupferteile ein Substrat (6), eine dielektrische Schicht (8) auf dem Substrat (6), wobei die dielektrische Schicht (8) eingebrachten Gräben (11) umfasst, eine Kupferschicht (12), welche das Dielektrikum (8) überdeckt und die Gräben (11) der dielektrischen Schicht (8) ausfüllt, wobei die Kupferschicht (12) im Bereich der Vertiefungen (11) Stufen (13) aufweist, wobei der Schritt a) folgende Unterschritte umfasst:

a1) mechanisch-chemisches Polieren der Kupferschicht (12) eines jeden Teils mit einer planarisierenden, chemischen Lösung bis zum Verschwinden der Stufen (13) und Erreichen einer im Wesentlichen planen Kupferoberfläche,
a2) mechanisch-chemisches Polieren der restlichen Kupferschicht mit einer bezüglich des Dielektrikum selektiven, nicht planarisierenden, chemischen Lösung bis zum vollständigen Entfernen von Kupfer auf der dielektrischen Schicht (8) außerhalb der Gräben (11), wobei das Kupfer auf gleicher Höhe wie das Dielektrikum bzw. in der Oberfläche des Dielektrikums versenkt bleibt,
a3) mechanisch-chemisches Polieren des Dielektrikums mit einer planarisierenden, chemischen Lösung bis die Oberfläche des Dielektrikums im Wesentlichen auf Höhe der Oberfläche der Kontaktpunkte ist.

**9.** Polierverfahren nach Anspruch 8, wobei die Teile eine Diffusionssperre zwischen dem Dielektrikum (8) und der Kupferschicht (12) aufweisen, bei Schritt a2) die Kupferschicht bis zu ihrem Verschwinden von der Diffusionssperre außerhalb der Gräben poliert wird, und bei Schritt a3) die Diffusionssparre vor dem Dielektrikum oder anstelle des Dielektrikums poliert wird.

**10.** Verfahren zur Haftverbindung nach einem der Ansprüche 1 bis 9, enthaltend einen zusätzlichen Schritt C) zum Tempern nach Schritt B).

**11.** Verfahren zur Haftverbindung nach einem der Ansprüche 1 bis 10, wobei das erste Teil in Form von einer Kupferplatte oder Kontaktpunkten vorliegt, die bündig mit einer Fläche eines dielektrischen Materials ist/sind, und das zweite Teil in Form von einer Platte oder Kontaktpunkten vorliegt, die bündig mit der Fläche eines Dielektrikums ist/sind.

**12.** Verfahren zum Herstellen einer mikroelektronischen Vorrichtung, enthaltend einen elektromechanischen Mikrosystemaufbau in einem hermetisch dichten Hohlraum, umfassend:

- einen Schritt des Herstellens eines ersten Teils, das mit einem elektromechanischen Mikrosystemaufbau versehen ist, der von einer ersten Wand aus Kupfer umgeben ist, die eine geschlossene Kontur bildet, wobei

der Scheitelpunkt der ersten Wand von einer ebenen Fläche gebildet wird,
- einen Schritt des Herstellens eines zweiten Teils, das mit einer zweiten Wand versehen ist, deren Scheitelpunkt von einer ebenen Fläche mit ähnlicher Form und ähnlichen Abmessungen wie die erste Wand des ersten Teils gebildet wird, wobei die Summe der Höhe jeweils der ersten und der zweiten Wand größer ist als die Höhe des elektromechanischen Mikrosystemaufbaus,
- einen Schritt des Polierens der ebenen Flächen der Wände jeweils des ersten und des zweiten Elements, mit denen die Teile in Kontakt gelangen, so dass eine Rauheit von unter 1 nm RMS, vorteilhaft kleiner oder gleich 0,5 nm RMS erreicht wird,
- einen Schritt des Reinigens der genannten Flächen, um aufgrund des Polierens vorhandene Partikel und Korrosionsinhibitoren zu beseitigen,
- einen Schritt des Inkontaktbringens mit dem Sauerstoff und des Bildens einer mit Sauerstoff angereicherten kristallinen Kupferschicht auf jeder der ebenen Flächen, wobei die Gesamtdicke der beiden Schichten unter 6 nm beträgt,
- einen Schritt des Inkontaktbringens der beiden mit Sauerstoff angereicherten kristallinen Kupferschichten, so dass der elektromechanische Mikrosystemaufbau in einem dichten Hohlraum verschlossen wird, der von dem ersten und dem zweiten Teil und von der ersten und der zweiten Wand begrenzt wird.

**13.** Herstellungsverfahren nach Anspruch 12, umfassend einen Schritt der Kontrolle der Atmosphäre innerhalb des so gebildeten Hohlraums.

**14.** Herstellungsverfahren nach Anspruch 13, wobei der Schritt des Inkontaktbringens unter Vakuum erfolgt.

## Claims

**1.** A method for bonding a first copper element onto a second copper element including at least:

A) a step for forming a crystalline copper layer enriched in oxygen on each of the surfaces of each of the first and second elements through which the elements will be in contact, the total thickness of both layers being less than 6 nm,
B) a step for putting both crystalline copper layers enriched in oxygen in contact with each other,
said step A) comprising:

a) at least one step for polishing the surfaces so as to obtain a roughness of less than 1 nm RMS, and hydrophilic surfaces,
b) at least one step for cleaning said surfaces in order to suppress the presence of particles due to the polishing and the major portion of corrosion inhibitors.

**2.** The bonding method according to claim 1, wherein the roughness is less than 0.5 nm RMS.

**3.** The bonding method according to claim 1 or 2, wherein step B) takes place at room temperature, at atmospheric pressure and in air.

**4.** The bonding method according to any of claims 1 to 3, wherein step B) takes place within two hours following step b).

**5.** The bonding method according to any of claims 1 to 4, including a step for applying a force on one of the elements tending to bring both crystalline copper layers enriched in oxygen closer to each other so as to initiate bonding.

**6.** The bonding method according to claim 4 wherein application of the force takes place only on one edge of one of the elements.

**7.** The bonding method according to any of claims 1 to 6, wherein the dense planes of the copper elements are oriented substantially parallel to the bonding surfaces.

**8.** The bonding method according to any of claims 1 to 7, the copper elements including a substrate (6), a dielectric layer (8) provided with etchings (11), deposited on the substrate (6), a copper layer (12) covering the dielectric (8) and filling the etchings (11) of the dielectric layer (8), said copper layer (12) including steps (13) at the etchings (11), in which step a) includes the following sub-steps:

a1) chemical mechanical polishing of the copper layer (12) of each element with a leveling chemical solution until the steps (13) disappear and a substantially planar copper surface is obtained,
a2) chemical mechanical polishing of the remaining copper layer with a selective non-leveling chemical solution relatively to the dielectric until the copper on the dielectric layer (8) apart from the etchings (11) is completely removed, the copper remaining at the same level as the dielectric or set back from the surface of the dielectric,
a3) chemical mechanical polishing of the dielectric with a leveling chemical solution until the surface of the dielectric is substantially at the surface of the pads.

**9.** The polishing method according to claim 8, wherein the elements include a diffusion barrier between the dielectric (8) and the copper layer (12), during step a2), the copper layer is polished until it disappears on the diffusion barrier apart from etchings, and during step a3), the diffusion barrier is polished before the dielectric or instead of the dielectric.

**10.** The bonding method according to any of claims 1 to 9, including an additional annealing step C) after step B).

**11.** The bonding method according to any of claims 1 to 10, wherein the first element is in the form of a copper plate or of pads flush with a surface of a dielectric material and the second element is in the form of a plate or of pads flush with a dielectric material surface.

**12.** A method for making a microelectronic device comprising an electromechanical microsystem structure in a hermetically sealed cavity comprising:

- a step for making a first element provided with an electromechanical microsystem structure surrounded by a first copper wall forming a closed contour, the top of said first wall being formed by a planar surface,
- a step for making a second element provided with a second wall, the top of which is formed by a planar face with shape and dimensions similar to that of the first wall of the first element, the sum of the heights of the first and second walls being greater than the height of the electromechanical microsystem structure,
- a step for polishing the planar faces of the walls of each of the first and second elements through which the elements will be in contact so as to obtain a roughness of less than 1 nm RMS, advantageously less than or equal to 0.5 nm RMS,
- a step for cleaning said faces in order to suppress the presence of particles due to the polishing and of corrosion inhibitors,
- a step for contact with oxygen and for forming a crystalline copper layer enriched in oxygen on each of the planer faces, the total thickness of both layers being less than 6 nm,
- a step for putting both oxygen-enriched crystalline copper layers in contact with each other so as to seal the electromechanical microsystem structure in a sealed cavity delimited by the first and second elements and the first and second walls.

**13.** The making method according to claim 12, including a step for controlling the atmosphere within the thereby formed cavity.

**14.** The making method according to claim 13, wherein the contacting step is carried out under vacuum.

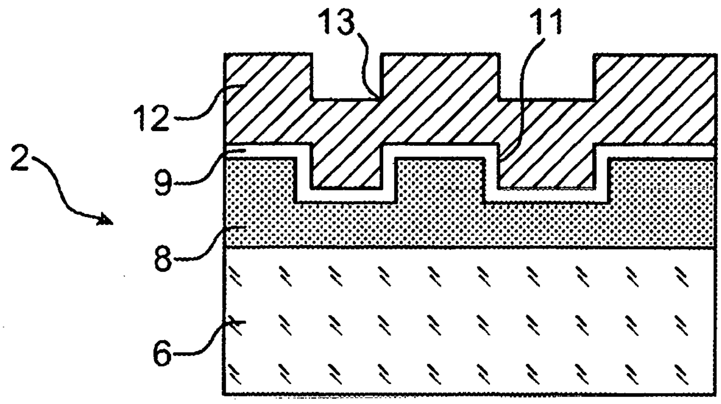


FIG.1A

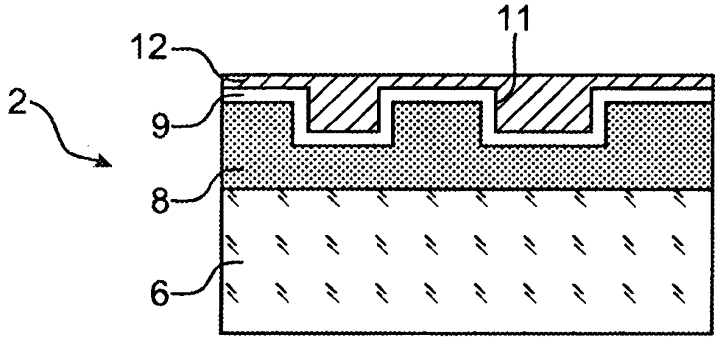


FIG.1B

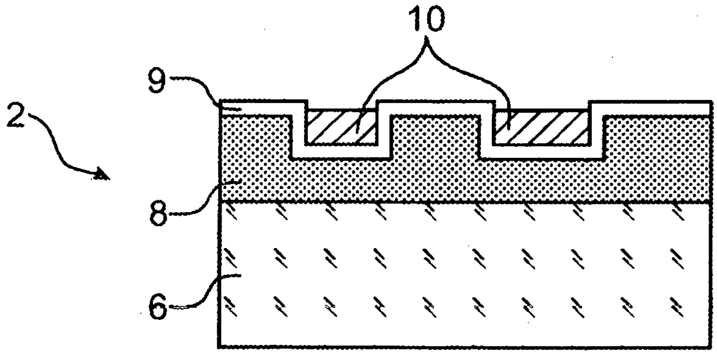


FIG.1C

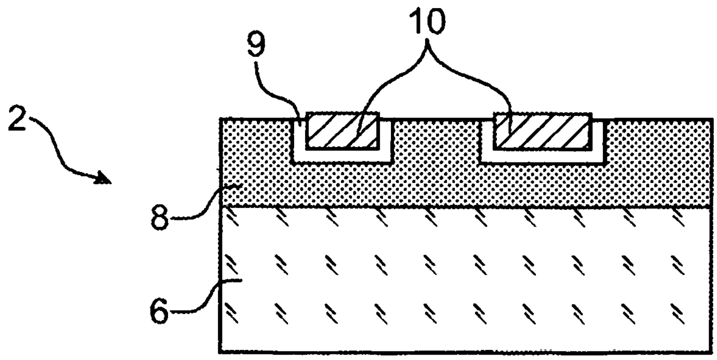


FIG.1D

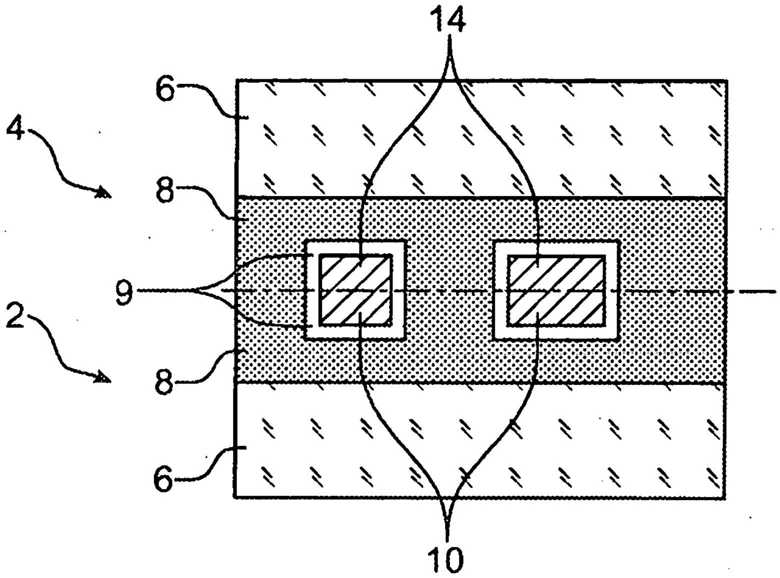


FIG.1E

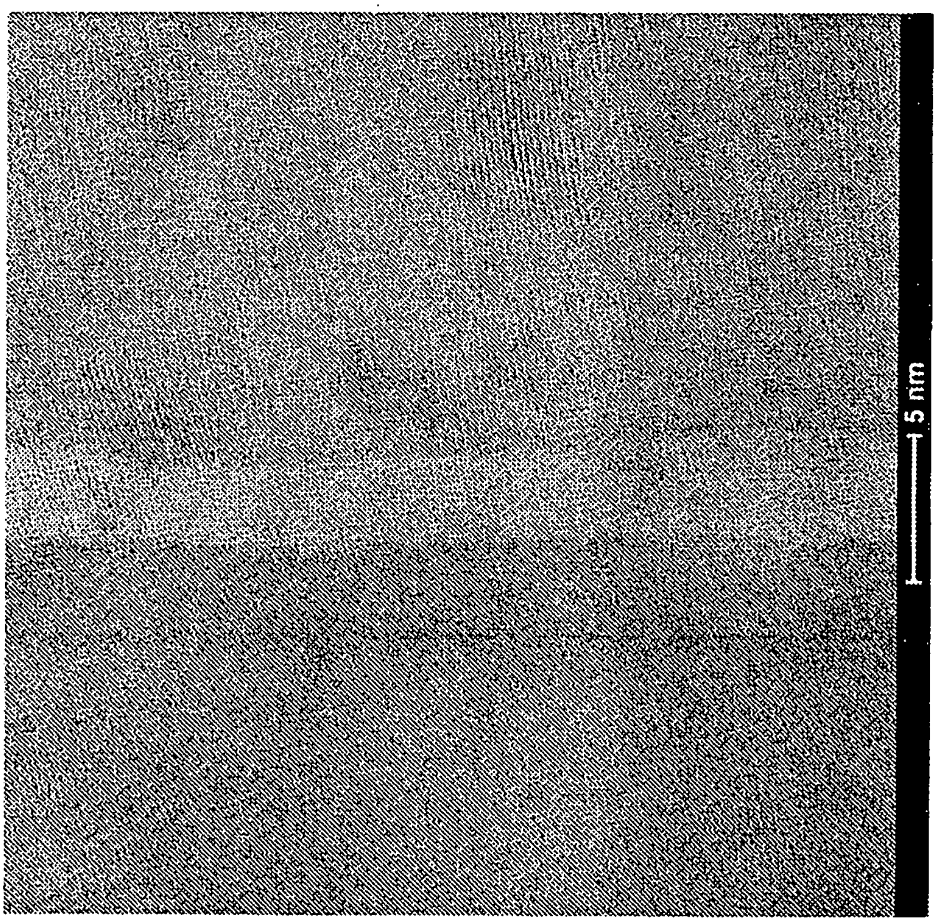


FIG.2

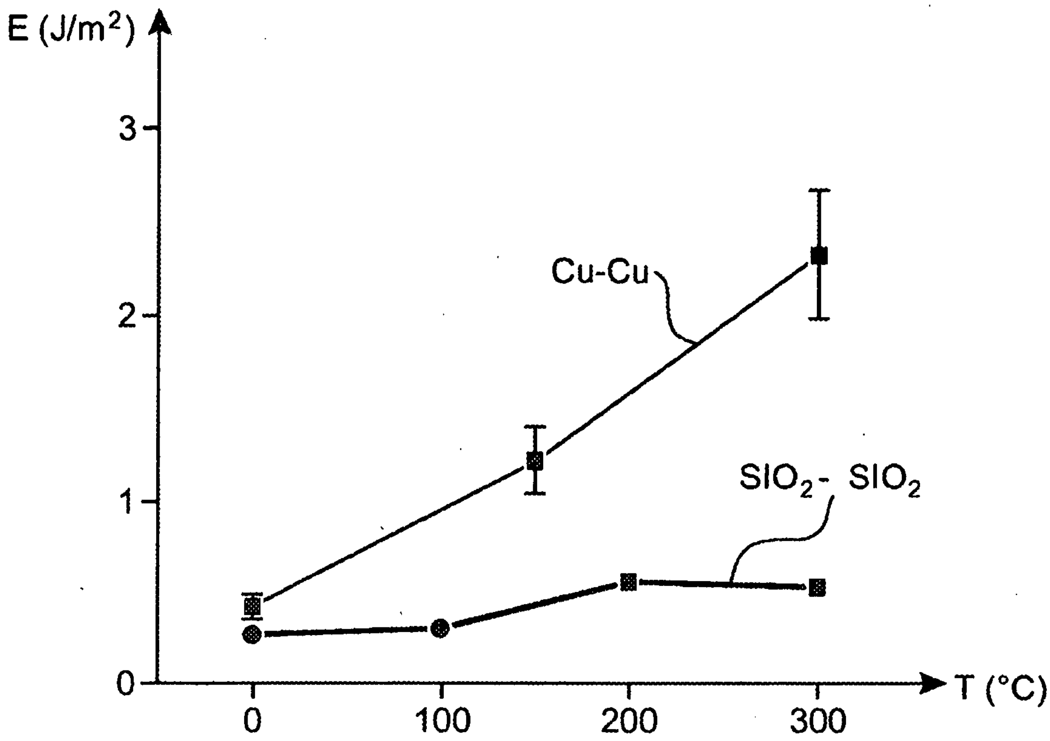
E (J/m2)
3
2
1
0
Cu-Cu
SIO2- SIO2
0
100
200
300
T (°C)

FIG.3

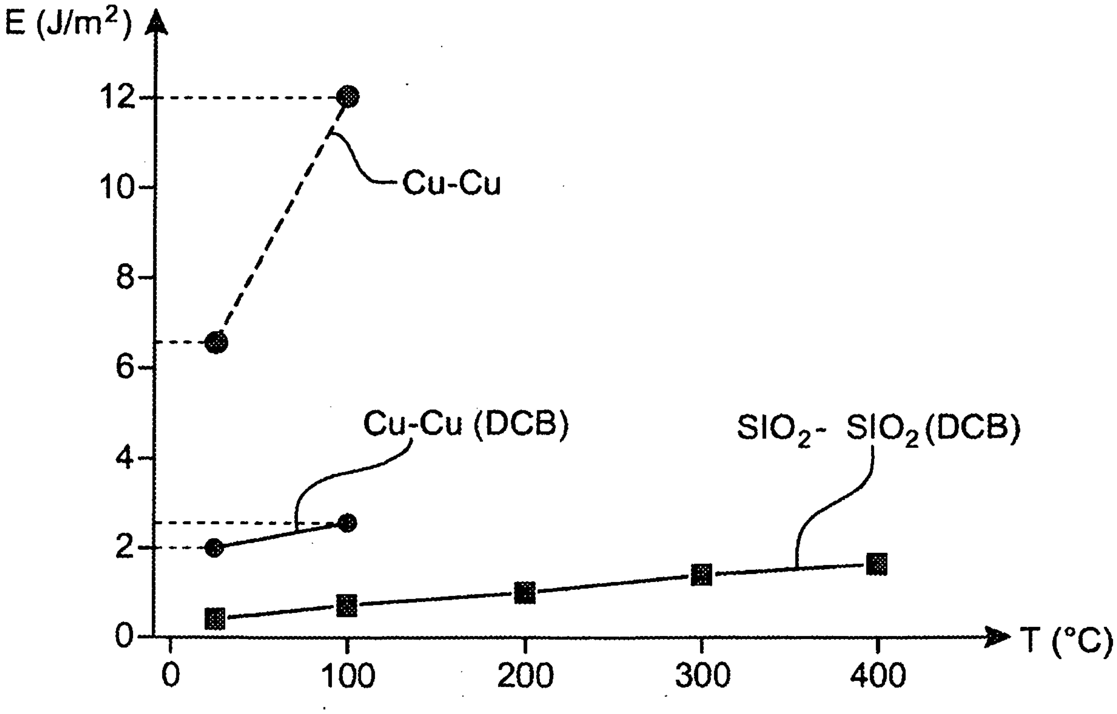
E (J/m2)
12
10
8
6
4
2
0
Cu-Cu
Cu-Cu (DCB)
SIO2- SIO2(DCB)
0
100
200
300
400
T (°C)

FIG.4

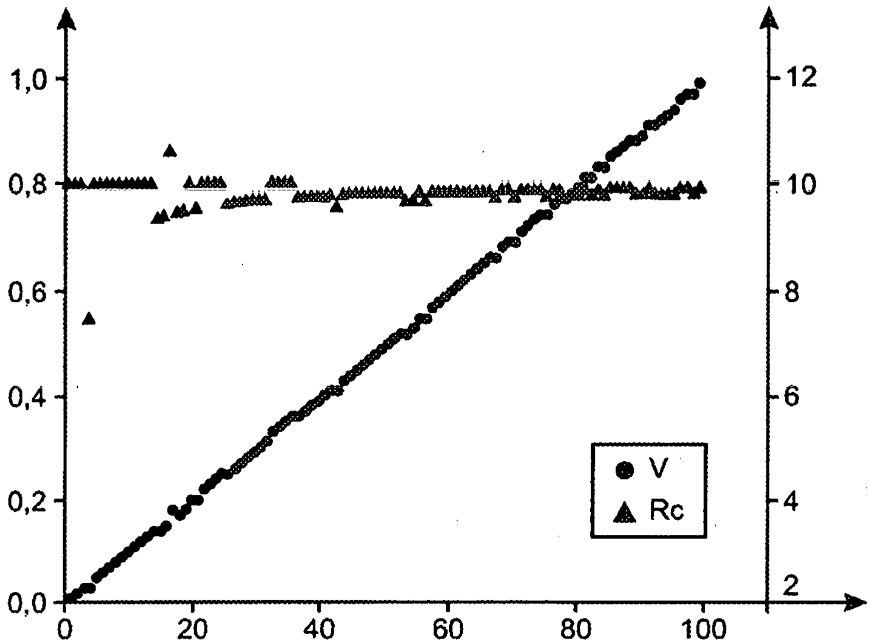


FIG.5A

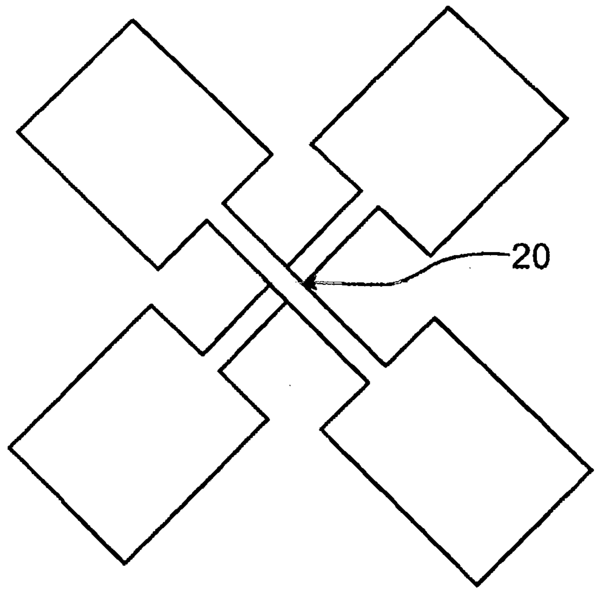


FIG.5B

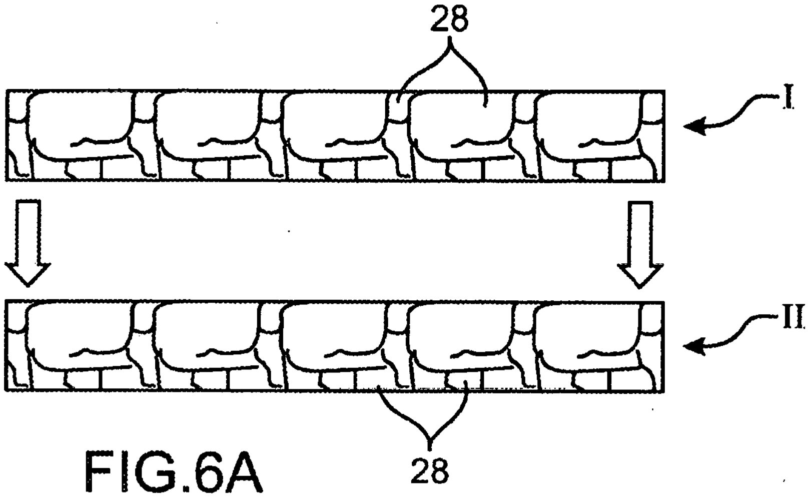


FIG.6A

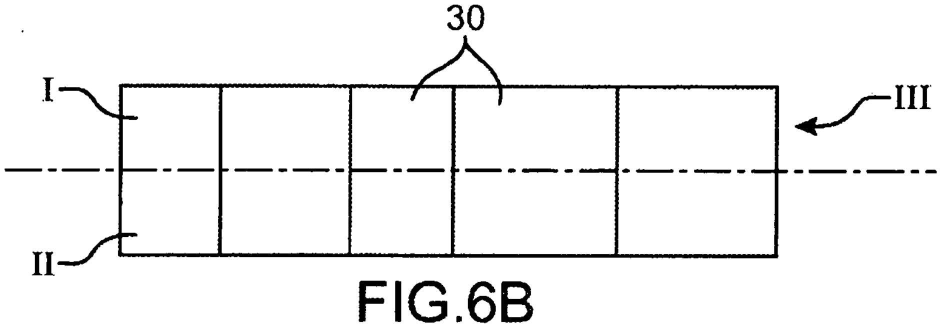


FIG.6B

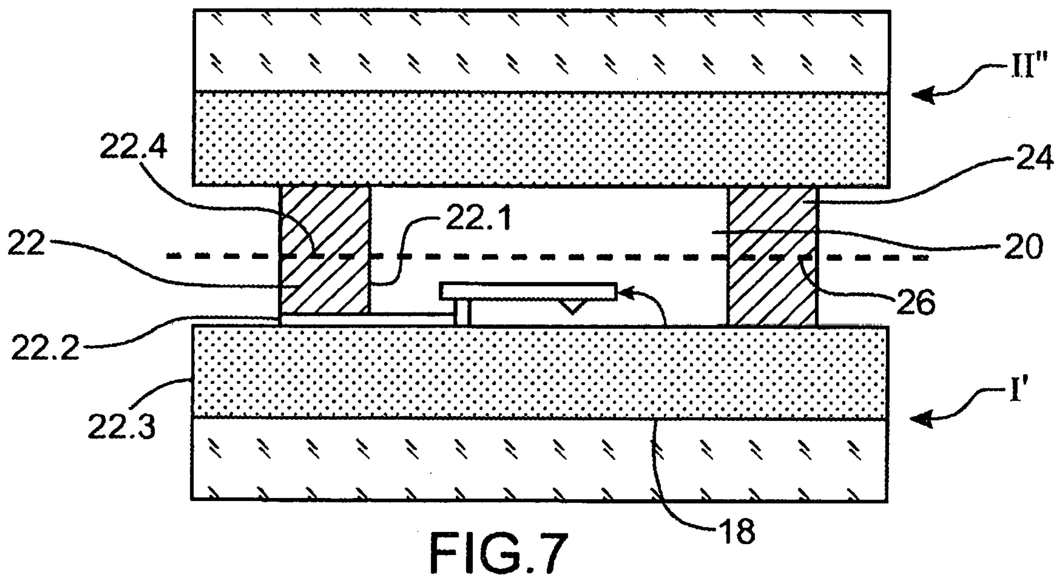


FIG.7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 6376260 B

### Littérature non-brevet citée dans la description

- **JAE Y.3 KIMND.** Reduction of CuO and Cu2O with H2: Embeding and Kinetic Effects in the Formation of Suboxides. *JACS,* 2003, 10684-10692